# EUROPEAN PATENT SPECIFICATION

(11) **EP 0 314 088 B1**
(45) Date of publication and mention of the grant of the patent: **30.08.1995**
(21) Application number: 88117811.5
(22) Date of filing: 26.10.1988
(51) Int. Cl.: A61B 5/05

(54) **Conductivity measuring device**
Leitfähigkeits-Messanordnung
Dispositif de mesure de conductivité

(30) Priority: 27.10.1987 JP 271351/87
(43) Date of publication of application: 03.05.1989
(73) Proprietor: NIHON SYSTEM RESEARCH INSTITUTE INC., Kawasaki-shi Kanagawa-ken (JP); Matsushita, Akira, Kawasaki-shi Kanagawa-Ken (JP)
(72) Inventor: Nakano, Shohkichi, Nakara-Ku Kawasaki-Shi Kanagawa-Ken (JP); Matsushita, Akira, Kawasaki-Shi Kanagawa-Ken (JP)
(74) Representative: Reichel, Wolfgang, Dipl.-Ing.

(56) References cited:
- FR-A- 2 444 279
- US-A- 3 971 366
- US-A- 4 178 916
- PATENT ABSTRACTS OF JAPAN, vol. 125, no. 8 (P-279), 12th June 1984 & JP-A-59028 646

## Description

### BACKGROUND OF THE INVENTION

### 1. Field of the Invention

This invention relates to a conductivity measuring device, and more particularly relates to a conductivity measuring device for measuring the conductivities of the surface and the inner portion of a body to be tested separately.

### 2. Description of the Prior Art

In order to measure the conductivity of a substance, such as the skin of a living body, which has a high electric specific resistance, and moreover has different conductivities for the surface layer and the deep portion thereof, a method has been utilized in which a couple of electrodes are contacted on the surface of a substance to measure conductivity between the electrodes. In such a conventional measuring method, however, it is difficult to measure the conductivities of the surface and the inner portion of a body separately.

When grounding resistance or the like is measured, Kohlrausch method, Wiechert method and the like are being tried, and the potentiometric grounding resistance meter, the constant current-type grounding resistance meter and the like are being utilized.

There are difficulties, however, in utilizing these methods for measuring conductivities each of which is different for the surface and the inner portion of a body to be tested, such as a living body or the like according to water content, blood or the like.

For a substance which has a high conductivity, such as a metal, it is possible to measure the conductivities of the surface and the inner portion separately to some extent by skin effect due to high-frequency wave. For a substance which has a low conductivity, however, such a method has only a small effect, and moreover, the frequency for obtaining the effect becomes very high. Hence, it cannot be put in practical use.

It will be noted that there is the following opinion. That is, cell membranes of subcutaneous cells of the skin of a living body have a very large electrostatic capacity (about 1 »F/cm) and so they can be considered as insulators. Hence, when the frequency of an applied power supply is low, only physiological liquid between cells contributes to the conductivity. When the frequency becomes high, however, current flows even in intercellular liquid through cell membranes (see, for example, Yutaka Kanai, "Basis of impedance measurement and its application to clinical practice," Journal of clinical inspection, pp.421-429, vol.26, No. 4, 1982-4).

Accordingly, it is said that, as for applied voltage between electrodes, it is effective to use that of low frequency for measuring surface current, while to use that of high frequency for measuring current in a deep portion which reaches subcutaneous cell membranes having large electrostatic capacities.

An actual skin shows, however, a considerably complicated pattern of conductivity from the surface to the inner portion, and electrical properties of each portion of a living body change every moment. Hence, it is difficult to generally simulate the skin by a simple model or an equivalent circuit.

Consequently, in the method of measuring conductivity from the surface of a skin by contacting electrodes thereto, it has hitherto been considered that it is extremely difficult to detect the conductivities of the surface and the inner portion separately.

A conductivity measuring device for measuring the conductivity of a body according to the preamble of claim 1 is known from JP-A-59 028 646.

### SUMMARY OF THE INVENTION

It is an object of the present invention to provide a simple measuring device capable of detecting conductivities at the surface and the inner portion of a body to be tested, such as a living body, which differ from each other according to water content or the like, respectively, by means of contacting specified electrodes to the body to be tested, and subsequently operating.

A conductivity measuring device of the present invention is characterised in that an intermediate electrode is situated between a transmitting electrode and a receiving electrode and being connectable through a switch to a terminal of a transmitter unit and a receiving unit according to claim 1.

On this occasion, each of the measuring electrodes for transmitting and receiving and the intermediate electrode may also be concentrically disposed, and these electrodes may be unified into a probe. The internal current of a body to be tested is measured by disposing the intermediate electrode between the measuring electrodes for transmitting and receiving, and subsequently the surface current is measured by making said intermediate electrode in open state by the switch, and the both measured values are operated so that the conductivity of the surface of said body to be tested can be exactly determined.

The device of the present invention can also be so constituted that an FM transmitter and a power supply battery are loaded in said probe whereby the measured results can be determined by an FM receiver.

The present invention has further characteristics such that the frequency of a power supply when the conductivity of the inner portion of a body to be tested is measured is set higher than that when the conductivity of the surface is measured, or each of said electrodes consists of a conductive soft material so as to contact the surface of a body to be tested in accordance with the shape of the surface or a body to be tested.

### BRIEF DESCRIPTION OF THE DRAWINGS

FIG. 1 is a configurational diagram of the principle showing an embodiment of the present invention;
FIGS. 2 and 3 are examples of dispositions of each electrode; and
FIGS. 4 and 5 show equivalent circuits of models in the case where the electrodes disposed as shown in FIGS. 2 and 3 are made contact with an body to be detected, respectively.

### DESCRIPTION OF THE PREFERRED EMBODIMENT

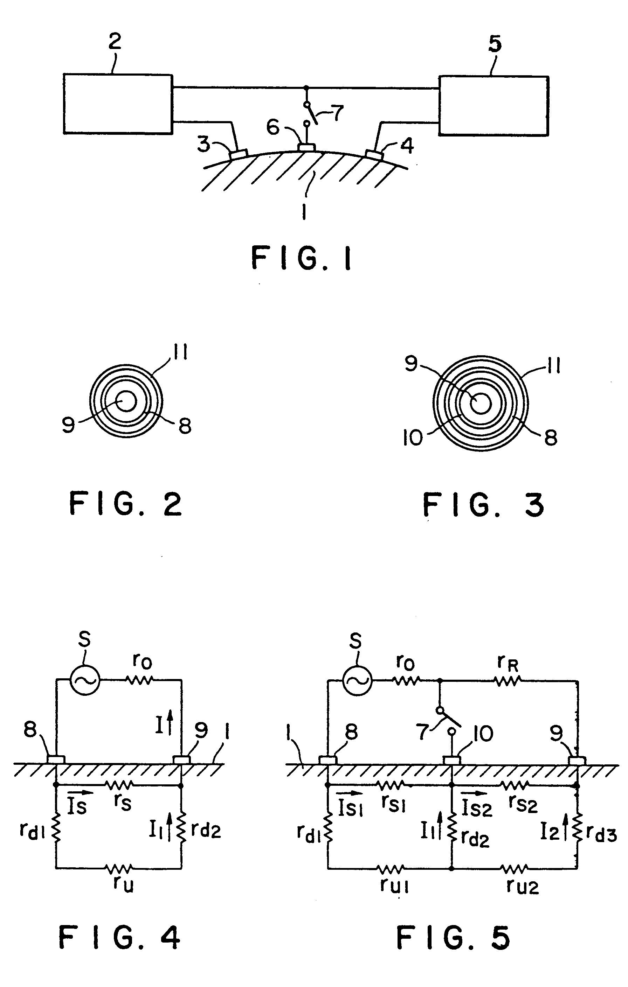

FIG. 1 shows a configurational example of the principle of a conductivity measuring device of the present invention. The device comprises a transmitting unit 2 for transmitting a frequency which fits properties of a body 1 to be tested, a transmitting electrode 3 for applying the transmitted output, a receiving electrode 4 for capturing the transmitted output which has passed the body 1 to be tested, a receiving unit 5 connected thereto, an intermediate electrode 6 set to a low potential or grounded potential which is situated between the transmitting electrode 3 and the receiving electrode 4 and a switch 7. On this occasion, an operational circuit for processing measured results of conductivity and a display circuit are equipped in the receiving unit 5.

FIG. 2 illustrates a conventionally-utilized disposition of electrodes for surface measurement in which each of electrodes to be made contact with a body to be tested is concentrically disposed. A circular electrode in the center is a receiving electrode 9, an annular electrode on the outer circumference thereof is a transmitting electrode 8, and on the utmost outer portion there is a guard ring 11 for preventing induction which is generally used with being grounded cf. JP-A-59 028 646.

On the contrary, FIG. 3 is a configurational example of each of concentrically-disposed electrodes used in the present invention, in which an intermediate electrode 10 is disposed between the receiving electrode 9 and the transmitting electrode 8.

First, a model of the surface and the inner portion, when a couple of electrodes 8 and 9 are pressed against a body to be tested and direct current is applied between the electrodes as shown in FIG. 2, i.e., a conventional method, is shown by a simple equivalent circuit in FIG. 4. Here, the circuit of the guard ring 11 is omitted, and the internal resistance r₀ of the transmitting source S is neglected because it is generally extremely small.

In FIG. 4, in general, the composite current I of the surface current Is which flows through the equivalent resistance rₛ of the surface portion of the body 1 to be tested and the inner current I₁ which flows through the resistances rd₁ and rd₂ of the vertical portions reaching the inner portion and the resistance ru of the deep portion in the horizontal direction can be measured.

In the composite current ( $\text{I=Is + I₁}$ ), although most of the current measured when the surface resistance is small ( $\text{rs < rd₁ + rd₂ + ru}$ ) is the surface current Is, the inner current I₁ is also included, and hence the measured current value is not the exact Is.

When the resistance of the surface portion is relatively large compared with the resistance of the inner portion, conductivity remarkably decreases because insulation resistance is large as a whole. The result of measurement under such circumstances sometimes fairly depends on the inner current I₁. Hence, the values of Is and I₁ cannot be obtained separately.

Let it be considered that the skin of a living body is selected as the body 1 to be tested. When the surface layer portion is in relatively dry state, its conductivity is small compared with that of the subcutaneous cell portion. Accordingly, it has been considered difficult to measure the discriminated values of the surface current Is and the inner current I₁ separately.

It has become possible, however, to measure, for example, the discriminated values Is and I₁ described above, by applying such electrode disposition illustrated in FIG. 3.

The equivalent circuit corresponding to the configuration in FIG. 3 can be illustrated in FIG. 5, in the same manner as in the above-described example.

In FIG. 5, the current in each portion can be represented by the surface current Is₁ which flows through the equivalent resistance rs₁ of the surface portion of the body 1 to be tested, the deep-portion current I₁ which flows through the resistances rd₁ and rd₂ of the vertical portions and the resistance ru₁ of the deep portion in the horizontal direction into the intermediate electrode 10, and the deep-portion current I₂ which flows through the resistances rd₁, ru₁, ru₂ and rd₃ into the receiving electrode 9, or the like.

Now, referring to the conductivity measurement of the surface of the body 1 to be tested on this occasion, when the switch 7 is made open, the situation is the same as in the measurement of surface current by the usual method which is equivalent to FIG. 4.

However, when the measurement is performed with the switch 7 closed, it is possible to obtain the conductivity of the inner portion depending on the deep-portion current I₂. On this occasion, it is effective when the distance from the intermediate electrode 10 to the receiving electrode 9 is arranged to be longer than the distance from the transmitting electrode 8 to the intermediate electrode 10.

That is, there exist the surface current Is₁ which flows through the surface resistance rs₁ and the deep-portion current I₁ which flows through the resistances rd₁, ru₁ and rd₂ of the deep portions between the transmitting electrode 8 and the intermediate electrode 10, and these currents can be treated as invalid components flowing into the intermediate electrode 10.

On the other hand, the composite current flowing into the receiving electrode 9 is the sum of the surface current Is₂ and the deep-portion current I₂.

The surface current Is₂ is, however, a current which flows through the surface resistance rs₂ having relatively large, between the intermediate electrode 10 set at a low potential, such as ground potential, and the receiving electrode 9, and so is extremely small. Hence, the current flowing into the receiving electrode 9 has a value which mostly depends on the deep-portion current I₂.

Accordingly, it is possible to measure each of the surface current and the deep-portion current by turning on and off the switch 7. Further, by storing the value of the surface current measured when the switch 7 is turned off, and subsequently performing an operation of substracting the value of the surface current thus stored from the value of the composite current flowing into the receiving electrode 9 when the switch 7 is turned on, it is possible to know the exact value of the deep-portion current. Here, r_{R} is the input resistance which exists between the receiving electrode 9 and the intermediate electrode 10.

By thus disposing the intermediate electrode 10 set at a low potential between a couple of measuring electrodes 8 and 9 for transmitting and for receiving, and organizing so as to measure with contacting each of these electrodes to the body 1 to be tested, it is possible to provide a measuring device which can detect the conductivities of the surface and the inner portion of the body to be tested which differ according to water content or the like.

In the equivalent circuit of the body 1 to be tested in the foregoing explanation, only resistance components have been illustrated. However, commercial frequency or high frequency is practically used as the transmitting source S.

Accordingly, it can be considered that, for example in the case of the skin of a living body, the body 1 to be tested consists of the surface which is a resistance having a different value according to perspiration state, and cell membranes of the subcutaneous tissue which are considered as an insulator having a large electrostatic capacity. Further, presuming that intercellular liquid wrapped by a cell membrane and extracellular liquid existing between cells are a kind of an electrolyte which has a low resistance, the equivalent circuit for this case can be considered by a model which is a series-parallel circuit of the resistance r and the electrostatic capacitance c.

Accordingly, for each of electrodes including an intermediate electrode according to the present invention, it is effective to provide means in which the frequency of the power supply frequency during the measurement of the conductivity of the inner portion of an body to be tested is set higher than that during the measurement of the conductivity of the surface.

Further, when the body to be tested has a curved surface or irregularity, each electrode may be constituted by a conductive soft material so that the electrode surface can contact the body to be tested in accordance with the shape of the surface of the body.

It is to be noted that although the above-described method is a non-destructive method because the measurement is performed by making contact each electrode with a body to be tested, a method in which needle-point electrodes are buried in a body to be tested, as is the case for plant, soil or the like, is also applicable to the present invention.

Further, adoption of the so-called cordless system wherein an FM transmitter and a power supply battery are loaded within a probe in which each electrode is disposed and unified, and the measured value by the probe is processed by wireless system including an FM receiver does not require a cable which connects the probe to a body of the measuring device, and therefore it has many advantages from the viewpoint of practical use.

According to the present invention, it is possible to detect the conductivities which differ at the surface layer and the deep portion separately, in a body to be tested, such as the skin of a living body, foodstuffs of animals and plants, concrete before caking, soil or the like.

Especially for a substance, such as subcutaneous cells of a living body, for which it is necessary to measure by non-destructive method, it becomes possible to measure conductivity or impedance of the surface layer and the inner tissue separately. Hence, the present invention can provide very effectively means for medical examination or foreseeing of the condition of a disease of the living body.

Furthermore, according to the present invention, it has become possible to perform a novel measurement by a very simple method. Moreover, the measuring system of the present invention can be very small in size and of low power consumption-type, and so it is possible to provide a low-priced portable device.

## Claims

1. A conductivity measuring device for measuring the conductivity of a body comprising a transmitting unit (2; S) having a first and a second terminal providing an output current; a receiving unit (5; r_{R}) including a circuit for measuring and processing input currents and having a third and a fourth terminal for receiving said input currents; a transmitting electrode (3; 8) connected to the first terminal; a receiving electrode (4; 9) connected to the fourth terminal; characterised by a switch (7) and an intermediate electrode (6; 10) situated between the transmitting electrode (3; 8) and the receiving electrode (4; 9) and being connectable through the switch (7) to the second terminal and to the third terminal, the second and the third terminal being connected with each other and the electrodes (3, 4, 6; 8, 9, 10) being adapted to be brought into contact with said body (1), the conductivity of which is to be measured.

2. A conductivity measuring device according to claim 1, wherein each of said measuring electrodes (8, 9) for transmitting and receiving and said intermediate electrode (10) are concentrically disposed and unified into a probe.

3. A conductivity measuring device according to claim 2, wherein an FM transmitter and a power supply battery (S) are loaded in said probe so that the measured results can be determined by an FM receiver.

## Patentansprüche

1. Leitfähigkeits-Meßanordnung zum Messen der Leitfähigkeit eines Körpers, mit einer Sendeeinheit (2; S), die einen ersten und einen zweiten Anschluß aufweist, die einen Ausgangsstrom liefern; einer Empfangseinheit (5; r_{R}) mit einer Schaltung zum Messen und Verarbeiten von Eingangsströmen und mit einem dritten und einem vierten Anschluß zum Aufnehmen der Eingangsströme; einer mit dem ersten Anschluß verbundenen Sendeelektrode (3; 8); und einer mit dem vierten Anschluß verbundenen Empfangselektrode (4; 9), **gekennzeichnet durch** einen Schalter (7) und eine Zwischenelektrode (6; 10), die zwischen der Sendeelektrode (3; 8) und der Empfangselektrode (4; 9) angeordnet und über den Schalter (7) mit dem zweiten Anschluß und dem dritten Anschluß verbindbar ist, wobei der zweite und der dritte Anschluß miteinander verbunden sind und die Elektroden (3, 4, 6; 8, 9, 10) mit dem Körper (1), dessen Leitfähigkeit gemessen werden soll, kontaktierbar sind.

2. Leitfähigkeits-Meßanordnung nach Anspruch 1, bei der alle zum Senden und Empfangen dienenden Meßelektroden (8, 9) und die Zwischenelektrode (10) konzentrisch angeordnet und in einer Sonde vereinigt sind.

3. Leitfähigkeits-Meßanordnung nach Anspruch 2, bei der ein FM-Sender und eine Stromversorgungs-Batterie (S) in der Sonde angeordnet sind, so daß die Meßergebnisse durch einen FM-Empfänger ermittelt werden können.

## Revendications

1. Dispositif de mesure de conductivité pour mesurer la conductivité d'un élément comprenant une unité d'émission (2 ; S) ayant une première et une seconde bornes délivrant un courant de sortie ; une unité de réception (5 : r_{R}), comportant un circuit pour mesurer et traiter des courants d'entrée, et possédant une troisième et une quatrième bornes pour recevoir lesdits courants d'entrée ; une électrode d'émission (3 ; 8) reliée à la première borne ; une électrode de réception (4 ; 9) reliée à la quatrième borne ; caractérisé par un commutateur (7) et une électrode intermédiaire (6 ; 10) située entre l'électrode d'émission (3 ; 8) et l'électrode de réception (4 ; 9) et susceptible d'être reliée par le commutateur (7) à la seconde borne et à la troisième borne, la seconde et la troisième bornes étant reliées entre elles et les électrodes (3, 4, 6 ; 8, 9, 10) étant conçues pour être amenées en contact avec ledit élément (1), dont la conductivité doit être mesurée.

2. Dispositif de mesure de conductivité selon la revendication 1, dans lequel chacune desdites électrodes de mesure (8, 9) pour la transmission et la réception, et ladite électrode intermédiaire (10), sont disposées concentriquement et unifiées en une sonde.

3. Dispositif de mesure de conductivité selon la revendication 2, dans lequel un émetteur à modulation de fréquence et une batterie d'alimentation (S) sont chargés dans ladite sonde de manière que les résultats mesurés puissent être déterminés par un récepteur à modulation de fréquence.
